(19) Europäisches Patentamt / European Patent Office / Office européen des brevets

(11) **EP 1 999 845 B1**

(12) **EUROPÄISCHE PATENTSCHRIFT**

(45) Veröffentlichungstag und Bekanntmachung des Hinweises auf die Patenterteilung:
**21.04.2010 Patentblatt 2010/16**

(21) Anmeldenummer: **07723546.3**

(22) Anmeldetag: **23.03.2007**

(51) Int Cl.:
*H03G 3/20* *(2006.01)*     *H03G 3/30* *(2006.01)*

(86) Internationale Anmeldenummer:
**PCT/EP2007/002597**

(87) Internationale Veröffentlichungsnummer:
**WO 2007/112868 (11.10.2007 Gazette 2007/41)**

(54) **VORRICHTUNG UND VERFAHREN ZUR BETRIEBSPARAMETERABHÄNGIGEN VERSTÄRKUNGSEINSTELLUNG IN FUNKEINRICHTUNGEN**

DEVICE AND METHOD FOR SETTING THE AMPLIFICATION WHICH IS DEPENDENT ON OPERATIONAL PARAMETERS IN RADIO DEVICES

DISPOSITIF ET PROCÉDÉ DE RÉGLAGE D'AMPLIFICATION DÉPENDANT DES PARAMÈTRES DE FONCTIONNEMENT DANS DES DISPOSITIFS RADIO

(84) Benannte Vertragsstaaten:
**DE FI FR GB IT SE**

(30) Priorität: **30.03.2006 DE 102006014778**

(43) Veröffentlichungstag der Anmeldung:
**10.12.2008 Patentblatt 2008/50**

(73) Patentinhaber: **Fraunhofer-Gesellschaft zur Förderung der angewandten Forschung e.V. 80686 München (DE)**

(72) Erfinder:
• **SPIES, Peter**
  **91074 Herzogenaurach (DE)**
• **ROHMER, Günter**
  **91058 Erlangen (DE)**
• **GERHÄUSER, Heinz**
  **91344 Waischenfeld (DE)**

(74) Vertreter: **Schoppe, Fritz et al Schoppe, Zimmermann, Stöckeler & Zinkler Patentanwälte Postfach 246 82043 Pullach bei München (DE)**

(56) Entgegenhaltungen:
WO-A-99/63656     FR-A- 2 690 021
JP-A- 11 168 334     US-A- 4 422 047

**Beschreibung**

Die folgende Erfindung bezieht sich auf ein Konzept für eine betriebsparameterabhängige Verstärkungseinstellung in Funkeinrichtungen und insbesondere bei mobilen Sendeempfängern.

Sendeempfänger (Transceiver) kommen heutzutage in vielen Gebieten zum Einsatz, im Mobilfunk beispielsweise bei DECT (DECT = Digital Enhanced Cordless Telecommunication), GSM (GSM = Global System for Mobile Communications), UMTS (UMTS = Universal Mobile Telecommunication System), PCS (PCS = Personal Communication Service), DCS (DCS = Digital Cellular System), Bluetooth aber auch in Transceivern für Telemetrieanwendungen, beispielsweise in den ISM-Bändern (ISM = Industrial, Scientific and Medical Band).

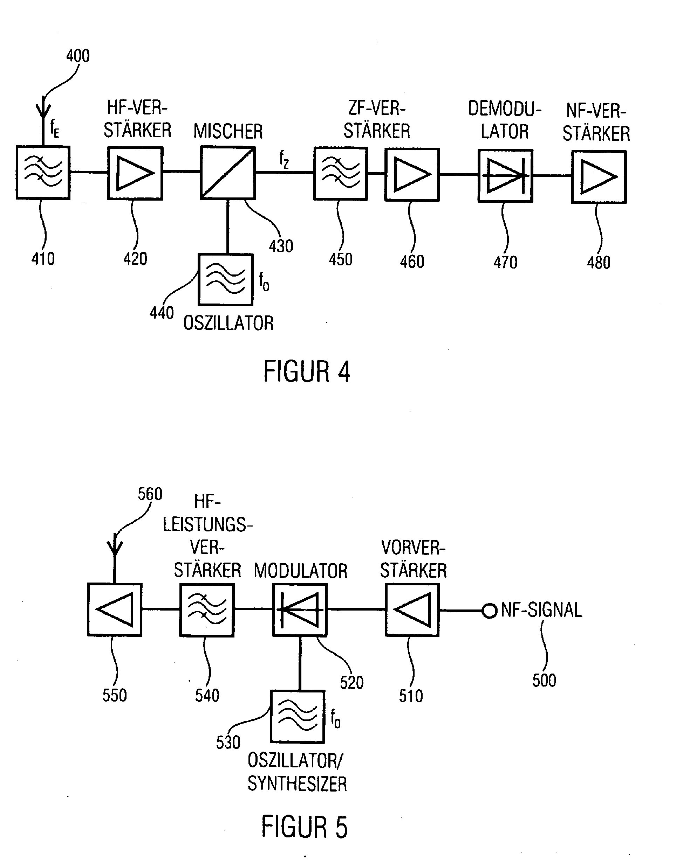

Die Leistungskontrolle funktioniert bei bekannten Empfängern nach dem Prinzip, dass ganze Systeme, die mehrere Blöcke wie Sende- oder Empfangspfade enthalten, ein- oder ausgeschaltet werden. In Fig. 4 ist nun beispielhaft die Struktur eines bekannten Empfängers beispielsweise für Mobilfunkgeräte vereinfachend als Blockschaltbild dargestellt, vgl. Q4, Meinke, Grundlach, "Taschenbuch der Hochfrequenztechnik", 5. Auflage, Springer-Verlag. Einer Empfangsantenne 400 nachgeschaltet befindet sich ein Hochfrequenz-Bandpassfilter 410, der das empfangene Signal auf die Systembandbreite beschränkt. Dem Bandpassfilter 410 nachgeschaltet ist ein Hochfrequenzverstärker 420, der die bandbegrenzten Empfangssignale verstärkt und einem Mischer 430 zuführt. Ein Oszillator 440 oder auch Synthesizer stellt dem Mischer 430 ein Signal der Mischfrequenz $f_0$ zur Verfügung, woraufhin nach dem Mischer 430 ein Signal bei der Zwischenfrequenz $f_z$ vorliegt. Ein Zwischenfrequenz-Bandpassfilter 450 filtert nun das Signal der Zwischenfrequenz und nimmt beispielsweise eine Kanalselektion vor. Ein nachgeschalteter Zwischenfrequenzverstärker 460 führt das verstärkte Zwischenfrequenzsignal einem Demodulator 470 (oder auch Detektor) zu, von dessen Ausgangsanschluss ein niederfrequentes Nutzsignal an einen Niederfrequenzverstärker 480 weitergegeben wird, um dann schließlich verstärkt vorzuliegen.

In Fig. 5 ist die Struktur eines bekannten Senders beispielsweise für Mobilfunkgeräte vereinfachend als Blockschaltbild beispielhaft dargestellt. Zunächst wird ein NF-Signal 500 mit einem Vorverstärker 510 verstärkt und einem Modulator 520 zugeführt, vgl. P, Meinke, Grundlach, "Taschenbuch der Hochfrequenztechnik", 5. Auflage, Springer-Verlag. Der Modulator erhält zusätzlich von einem Oszillator/Synthesizer 530 ein Signal mit der Trägerfrequenz $f_0$. Dem Modulator nachgeschaltet ist ein Hochfrequenz-Bandpassfilter 540, der das Ausgangssignal des Modulators 520 filtert und das gefilterte Signal einem Hochfrequenz-Leistungs-Verstärker 550 (PA = Power Amplifier) zuführt. Das verstärkte Signal wird dann über die Sendeantenne 560 abgestrahlt.

Um nun Verlustleistung solcher Sende- bzw. Empfangsanordnungen einzusparen, werden einzelne Blöcke oder Abschnitte, bzw. Teilsysteme derselben, sofern sie nicht unmittelbar gebraucht werden, in leistungseffizientere Zustände, sogenannte Standby-Zustände versetzt, in denen die volle Funktionalität dieser Blöcke nicht mehr zu Verfügung steht, diese aber erheblich weniger Leistung verbrauchen und relativ schnell wieder zu voller Funktionalität gebracht werden können. Auf diese Art und Weise werden einzelne Blöcke bzw. Teilsysteme aktiviert oder deaktiviert.

So werden beispielsweise während des Sendens der Mischer 430, die Zwischenfrequenzverstärker 460 und der FM-Detektor 470 (FM = Frequenzmodulation), soweit vorhanden, deaktiviert. Während des Empfangs dagegen wird die Sendeendstufe 550 und der Vorverstärker 510 ausgeschaltet. Der Oszillator/Synthesizer 440/530 wird während beider Betriebszustände benötigt und kann nur dann in einen Standby-Betriebszustand versetzt werden, wenn weder gesendet noch empfangen wird.

Bei den bisher bekannten Sende-Empfangsstufen von mobilen Sendeempfängern werden also einzelne Komponenten bzw. Teilsysteme entweder ein- oder ausgeschaltet, jedoch erfolgt keine kontinuierliche dynamische Steuerung von Funktionsblöcken. Lediglich die Verstärkung des Zwischenfrequenzverstärkers (ZF-Verstärker = Zwischenfrequenzverstärker) sowie der Sendeendstufe (PA) wird teilweise dynamisch während des Betriebs geregelt. Die Steuerung des Zwischenfrequenzverstärkers geschieht durch Messung der Empfangssignalstärke (RSSI = Receive Signal Strength Indicator = Empfangssignalpegel-Indikator) und automatischer Regelung der Verstärkung entsprechend dem empfangenen Signalpegel (AGC = Automatic Gain Control = automatische Verstärkungsregelung). Die Messung der Signalstärke geschieht mit logarithmischen Verstärkern, welche i.a. aus einer unterschiedlichen Anzahl hintereinander geschalteter begrenzender Verstärkerstufen bestehen. Diese Verstärker verbrauchen aber selbst relativ viel Verlustleistung, wobei die Steuerung des ZF-Verstärkers nicht mit dem Ziel der Verlustleistungsreduzierung ausgeführt wird, sondern hauptsächlich um für die nachfolgenden Komponenten (Analog-Digital-Wandler, Demodulator) ein möglichst konstantes Eingangssignal zu erzeugen und somit deren erforderlichen Dynamikbereich zu begrenzen.

Nachteilig an dieser bekannten Vorgehensweise ist, dass die einzelnen Komponenten von Sende- bzw. Empfangsanordnungen für Mobilfunkgeräte für die schlechtesten Empfangs- und Sendebedingungen, also für den "Worst-Case", ausgelegt sein müssen. "Worst-Case" bedeutet vor allem das Auftreten von maximal vielen Nachbarkanalstörern zusammen mit einer minimalen Empfangsleistung des Nutzsignals. Für den Normalbetrieb sind deshalb viele Funktionsblöcke für die eigentlichen Aufgaben überdimensioniert und verbrauchen so relativ viel Verlustleistung. Die Empfangssignalstärke kann beispielsweise bei DECT-Systemen jedoch zwischen -94 dBm und +10 dBm variieren, wobei aber nur in den seltensten Fällen die Empfangsleistung den Minimalwert erreicht. Auch erreichen die Nachbarkanalstörer selten die in den Spezifikationen angegebenen Maximalwerte, sofern Nachbarkanalstörer überhaupt vorhanden sind.

Um nun in der Praxis einen schnellen Verbindungsaufbau und eine permanente Erreichbarkeit zu ermöglichen, müssen die Komponenten des Empfängers öfter aktiviert werden als die des Senders. Somit ist auch der Beitrag dieser Komponenten zum Gesamtleistungsverbrauch relativ hoch.

Da sich Funkwellen auf ihrem Weg von einem Sender zu einem Empfänger entlang verschiedener Pfade ausbreiten und sich dann beim Empfänger konstruktiv bzw. destruktiv überlagern können, kann es zu schnellen Fluktuationen der Empfangsleistung kommen. Diese Fluktuationen ändern sich bereits bei räumlichen Verschiebungen im Bereich von etwa halben Wellenlängen und sind somit sowohl von der Frequenz als auch von der Geschwindigkeit mobiler Sender und Empfänger abhängig. Weiterhin werden sie von bewegten Hindernissen, Reflektoren, etc. im Funkfeld hervorgerufen und beeinflusst. Die momentan bekannten Verstärkerregelungen (beispielsweise mittels AGC-Anordnungen) werden mit Hilfe von digitalen Schaltungen und Mikroprozessoren gesteuert. Dadurch entstehen Verzögerungszeiten aufgrund der Analog-Digitalwandlung und der Datenverarbeitung. Daher können diese Systeme häufig nicht auf schnelle Kanaländerungen, wie sie im Funkkanal entstehen, reagieren. Sie können also den durch die Überlagerung entstehenden Mehrwegeschwund häufig nicht ausregeln.

Ein weiterer Nachteil bisher bekannter Mobilfunkempfänger ist ebenfalls, dass zur Basisstationssuche der Empfänger häufig aktiv sein muss, und so dessen erforderlicher Betriebsstrom entscheidend zum Gesamtleistungsbudget eines Funkempfängers beiträgt.

Die US 5,311,143 offenbart eine Schaltung, die es ermöglicht, einen Offset(Bias) eines Verstärkers zu regeln. Dabei wird ein Detektor verwendet, der einen Versorgungsstrom des Verstärkers kontrolliert. Eine Versorgungsschaltung, die mit dem Detektor gekoppelt ist, regelt dann den Offset des Verstärkers in Abhängigkeit des Versorgungsstroms. Die US 5,311,1143 weist das Problem auf, dass beispielsweise durch einen Funkkanal hervorgerufene schnelle Schwankung in einer Empfangsleistung, zwar Offset kompensiert, jedoch nicht ausgeregelt werden können. Demzufolge verbleiben entsprechende Schwankungen auch im Ausgangssignal der Verstärkungsschaltung.

Die US 6,642,784 B2 offenbart eine Verstärkungsregelungsschaltung für einen Leistungsverstärker, wie er beispielsweise in Sendeendstufen vorkommt, um ein Sendesignal zu verstärken, bevor es über eine Sendeantenne abgestrahlt wird. Die Verstärkungsregelung weist ferner eine Kalibrierungsschaltung auf, so wie eine Auskoppeleinrichtung, die aus dem Ausgangssignal des Verstärkers einen Signalteil auskoppelt, auf Basis dessen die Verstärkung geregelt werden kann. Die US 6,642,784B2 befasst sich jedoch nicht, mit den schnellen Schwankungen, die beispielsweise in einem Funkkanal auftreten, und beim Empfang von Funksignalen problematisch sind. Die in der US 6,642,784B2 gezeigten Verstärker und Verstärkungsschaltungen, beziehen sich auf Leistungsverstärkungen, wie sie in Funksendern vorkommen, und deren Konzepte sich nicht direkt auf Empfangsverstärker übertragen lassen, da beim Empfang von Funksignalen sehr geringe Pegel rauscharm verstärkt werden müssen, wobei die dort verwendeten Verstärker keine Leistungsverstärker im Sinne der US 6,642,784 B2 sind.

Die Veröffentlichung Klaus Schmalz "A 1 GHz AGC Amplifier in BiCMOS with 3 $\mu$s settling-Time for 802.11a WLAN", Norchip Conference, 2004, in Proceedings 8-9 Nov. 2004, Seiten 289-292 beschreibt ein Konzept zur Regelung einer Verstärkung bei einer Zwischenfrequenz in einem WLAN-System (WLAN = Wireless Local Area Network). Die dort beschriebenen Konzepte beziehen sich auf WLAN-Systeme, die nur für eingeschränkte Mobilitäten, wie sie beispielsweise im Heimbereich oder in Flughäfen usw. vorkommen, ausgelegt sind. Diese Systeme weisen im Normalfall keine schnellen Schwankungen auf, so dass eine Verstärkungsregelung bei einer Zwischenfrequenz, beispielsweise bei 810 MHz, geschehen kann. Die offenbarten Verstärkungsregelungen lassen sich nicht zum Ausregeln von schnellen Schwunderscheinungen in Mobilfunkkanälen, wie sie beispielsweise bei GSM vorkommen können und auch nicht in einem HF-Bereich eines Funkempfängers verwenden.

Die US 4,422,047 offenbart einen Hochfrequenzleistungsverstärker der ein hochfrequentes Empfangssignal eines Mehrkanalsenders verstärkt. Dabei kommen Feldeffekttransistoren als Verstärker zum Einsatz, wobei aus den Ausgangssignalen Signalanteile ausgekoppelt werden und einem Frequenzzähler zugeführt werden. Eine digitale Signalverarbeitungsschaltung schaltet dieses Signal dann einem entsprechenden Bandpassfilter zu, der Breitbandrauschen unterdrückt. Zusätzlich wird das Ausgangssignal des Leistungsverstärkers abgetastet, so dass der Verstärkungsfaktor des Leistungsverstärkers kontrolliert werden kann, insbesondere um ein Stehwellenverhältnis am Verstärkerausgang zu kontrollieren.

Ausgehend vom Stand der Technik, besteht die Aufgabe der vorliegenden Erfindung darin, ein verbessertes Konzept zum Betreiben von Funkeinrichtungen zu schaffen, mittels dem beispielsweise ein Empfänger mit geringerem Leistungsverbrauch aber ohne Performance-Verlust betrieben werden kann.

Diese Aufgabe wird durch eine Vorrichtung gemäß Anspruch 1 und ein Verfahren gemäß Anspruch 16 gelöst. Weiterbildungen sind in den abhängigen Patentansprüchen angegeben.

Der Kerngedanke der vorliegenden Erfindung besteht darin, eine schnelle und leistungseffiziente Regelung der Empfangsverstärkung einer Funkeinrichtung und insbesondere eines mobilen Empfangsgeräts, z.B. eines Mobilfunkgeräts, zu realisieren, indem die erforderlichen schnellen Reaktionszeiten durch ausschließliches Einsetzen von Analogtechnik realisiert werden. Die vorliegende Erfindung bezieht sich dabei generell auf Funkeinrichtungen, wie sie beispielsweise in Sendern, Empfängern und Sendeempfängern in vielen Bereichen, wie z.B. Mobilfunk, Rundfunk, Navigation usw. vorkommen.

Dies wird erfindungsgemäß durch eine Verstärkungsvorrichtung erreicht, die beispielsweise als eine Eingangsverstärkungseinrichtung realisiert ist, die ein Einganssignal verstärkt und durch einen steuerbaren Verstärker realisiert wird. Ferner ist eine Auskoppeleinrichtung nachgeschaltet, die aus dem verstärkten Eingangssignal einen Signalanteil auskoppelt (z.B. 0,1% dessen Leistung), der von der Leistung des verstärkten Eingangssignals, der sogenannten Ist-Leistung, abhängt, wobei die Auskoppeleinrichtung beispielsweise durch einen Richtkoppler realisiert werden kann. Eine Aufbereitungseinrichtung leitet dann aus dem ausgekoppelten Signal ein Maß für die Ist-Leistung ab, wobei das Ableiten beispielsweise durch Quadrieren und Mitteln eines Signalanteils realisiert werden kann, z.B. durch Einsatz eines RMS-DC-Wandlers (RMS = Root Mean Square = Mittelwert des Quadrates, DC = Direct Current = Gleichstrom). Eine Verarbeitungseinrichtung vergleicht nun das von der tatsächlichen Ist-Leistung abgeleitete Signal mit einem Sollwert, der wiederum ein Maß für die gewünschte Ist-Leistung des verstärkten Eingangssignals darstellt. Basierend auf diesem Vergleich wird der Verstärker angesteuert. Diese Verarbeitungseinrichtung wird beispielsweise durch eine Operationsverstärkerschaltung realisiert.

Durch den so entstehenden analogen Regelkreis können die Schwankungen, die durch den Funkkanal hervorgerufen werden, erfindungsgemäß betriebsparameterangepasst schnell und leistungseffizient ausgeregelt werden, und kann damit die Verlustleistung eines Empfangsverstärkers auf ein notwendiges Maß reduziert werden. Die durch die Analogtechnik erreichte Dynamik, ist dabei insbesondere auch zur Regelung von Eingangverstärkern in Funkempfängern geeignet. Durch die Regelung reduziert sich die Gesamtverlustleistung des Funkempfängers, wodurch wiederum beispielsweise längere Batterielaufzeiten in mobilen Empfängern, wie z.B. Mobilfunktelefonen, PDAs, Laptops etc. erreicht werden können.

Durch den Einsatz z.B. eines RMS-DC-Wandlers lässt sich also erfindungsgemäß einerseits eine einfache Steuerschleife zur Verstärkungseinstellung und damit eine Reduzierung der Verlustleistung realisieren, andererseits eine leistungseffiziente Alternative zu logarithmischen Verstärkern realisieren, da der Leistungsverbrauch solcher erfindungsgemäßen, analogen Regelschleifen selbst, gemessen an der erzielten Ersparnis, gering ist. Um die Regelschleife an die zeitlichen Anforderungen, die die zeitweise schnellen Fluktuationen im Funkkanal mit sich bringen, anzupassen, wird dabei auf Digitaltechnik verzichtet und der Regler in Analogtechnik durch Einsetzen von Operationsverstärkern realisiert. Operationsverstärkerschaltungen bieten darüber hinaus die Möglichkeit, durch eine entsprechende Beschaltung mit analogen Bauelementen (wie z.B. resistiven, induktiven und/oder kapazitiven Elementen) eine den jeweiligen Anforderungen gerecht werdende Regelcharakteristik zu etablieren, und die aktiven Verstärker in einem Empfänger entsprechend zu steuern. Durch diese Steuerung wird der Leistungsverbrauch dieser Komponenten bis auf ein Minimum reduziert und somit auch der Gesamtverbrauch des Empfängers reduziert.

Bevorzugte Ausführungsbeispiele der vorliegenden Erfindung werden nachfolgend unter Bezugnahme auf die beiliegenden Zeichnungen näher erläutert. Es zeigen:

Fig. 1     ein prinzipielles Blockschaltbild mit Funktionsblöcken der erfindungsgemäßen Vorrichtung zur leistungseffizienten Verstärkungseinstellung in Funkeinrichtungen;

Fig. 2     eine schematische Darstellung einer möglichen technischen Realisierung der erfindungsgemäßen Vorrichtung zur leistungseffizienten Verstärkungseinstellung in Funkeinrichtungen und insbesondere der Regelschleife zur Steuerung der Vorspannung/Versorgungsspannung eines rauscharmen Eingangsverstärkers (LNA);

Fig. 3     eine schematische Darstellung einer alternativen möglichen technischen Realisierung der erfindungsgemäßen Vorrichtung zur leistungseffizienten Verstärkungseinstellung in Funkeinrichtungen und insbesondere der Regelschleife zur Steuerung der Vorspannung/Versorgungsspannung eines rauscharmen Eingangsverstärkers (LNA);

Fig. 4     den prinzipiellen Aufbau eines bekannten Empfängers für Mobilfunkgeräte gemäß dem Stand der Technik; und

Fig. 5     den prinzipiellen Aufbau eines bekannten Senders für Mobilfunkgeräte gemäß dem Stand der Technik.

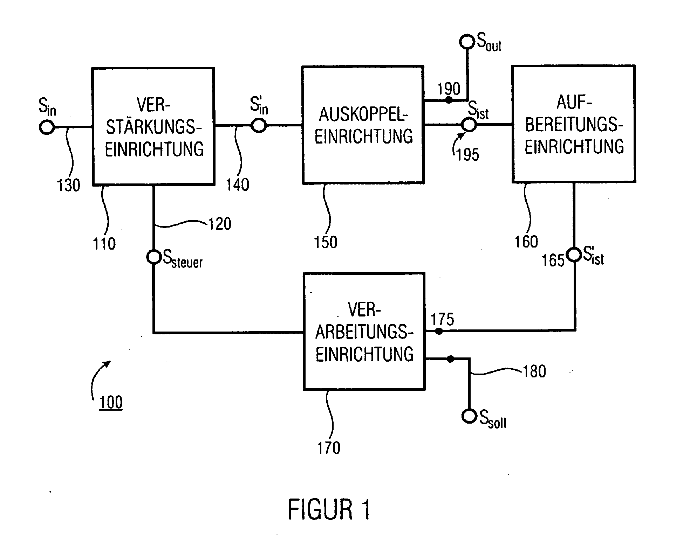

Im Nachfolgenden werden nun Bezug nehmend auf die beiliegenden Fig. 1 bis 3 bevorzugte Ausführungsbeispiele des erfindungsgemäßen Konzepts zur betriebsparameterabhängigen Verstärkungseinstellung in Funkeinrichtungen detailliert dargelegt. Bezüglich der nachfolgenden Beschreibung der bevorzugten Ausführungsbeispiele der vorliegenden Erfindung sollte beachtet werden, dass in den unterschiedlichen Figuren für funktional identische bzw. gleich wirkende oder gleichartige Elemente zur Vereinfachung in der gesamten Beschreibung die gleichen Bezugszeichen verwendet werden, und diese Elemente somit untereinander austauschbar sind.

Die nachfolgenden Erläuterungen werden im Bezug auf einen Funkempfänger ausgeführt, sind aber allgemein auf Verstärkerregelungen, wie sie beispielsweise in Empfangsverstärkern, Sendeverstärkern, Zwischenfrequenzverstärkern usw. zum Einsatz kommen, anwendbar. Die vorliegende Erfindung bezieht sich allgemein auf Funkeinrichtungen, d.h. Sender, Empfänger und Sendeempfänger, wie sie in vielen Bereichen wie z.B. Mobilfunk, Rundfunk, Telemetrie, Navigation etc. eingesetzt werden.

Im Folgenden wird nun Bezug nehmend auf Fig. 1 beispielhaft der Aufbau eines Regelkreises zur leistungseffizienten Regelung eines Funkempfängers gemäß einem ersten Ausführungsbeispiel der vorliegenden Erfindung detailliert erläutert, wobei in Fig. 1 zunächst das Prinzip anhand eines Blockschaltbildes prinzipiell erläutert wird.

Fig. 1 zeigt einen Ausschnitt eines prinzipiellen Funkempfängers 100 mit dem Regelkreis zur betriebsparameterabhängigen Verstärkungseinstellung gemäß der vorliegenden Erfindung. Die im folgenden beschriebenen Signale beziehen sich auf den Betriebszustand der erfindungsgemäßen Funkeinrichtung 100. Die Funkeinrichtung 100 besteht aus einer Verstärkungseinrichtung 110, die beispielsweise als eine Eingangsverstärkungseinrichtung (Eingangsstufe) realisiert sein kann, mit einem Steueranschluss 120, an dem ein Steuersignal $S_{steuer}$ anliegt, einem Eingangsanschluss 130, an dem ein Eingangssignal $S_{in}$ anliegt, und einem Ausgangsanschluss 140, an dem ein Ausgangssignal $S_{in}$' anliegt, das dem verstärkten Eingangssignal $S_{in}$ entspricht. Ober den Steueranschluss 120 wird die Verstärkungseinrichtung 110 mit dem Steuersignal $S_{steuer}$ ein Verstärkungsfaktor vorgegeben, mit dem das an dem Eingangsanschluss 130 anliegende Eingangssignal $S_{in}$ verstärkt wird, wobei das verstärkte Eingangssignal $S_{in}$' an dem Ausgangsanschluss 140 bereitgestellt bzw. ausgegeben wird.

Ausgangsseitig der Verstärkungseinrichtung 110 nachgeschaltet befindet sich eine Auskoppeleinrichtung 150. Die Auskoppeleinrichtung 150 hat zwei Ausgangsanschlüsse 190 und 195. Die Auskoppeleinrichtung 150 koppelt aus dem Ausgangssignal $S_{in}$' der Verstärkungseinrichtung 110 ein von diesem abhängiges Auskoppelsignal $S_{ist}$ aus und gibt dieses am Ausgangsanschluss 195 aus, d.h. das Auskoppelsignal $S_{ist}$ steht in einem vorbestimmten bzw. bekannten Verhältnis zu dem Ausgangssignal $S_{in}$' der Verstärkungseinrichtung 110 bzw. zu der Leistung des Ausgangssignals $S_{in}$'. Am Ausgangsanschluss 190 der Auskoppeleinrichtung 150 wird das Ausgangssignal $S_{out}$ bereitgestellt. Der Auskoppeleinrichtung 150 nachgeschaltet ist eine Aufbereitungseinrichtung 160. Die Aufbereitungseinrichtung 160 bereitet das von der Auskoppeleinrichtung 150 zur Verfügung gestellte Auskoppelsignalsignal $S_{ist}$ analog auf und stellt nun an ihrem Ausgangsanschluss 165 ein aufbereitetes Auskoppelsignal $S_{ist}$' zur Verfügung, das ein Maß für die von der Verstärkungseinrichtung 110 abgegebene Leistung, die sogenannte Ist-Leistung des verstärkten Eingangssignals $S_{in}$', ist.

Der Aufbereitungseinrichtung 160 nachgeschaltet ist die Verarbeitungseinrichtung 170. Die Verarbeitungseinrichtung 170 weist einen ersten Eingangsanschluss 175 und einen zweiten Eingangsanschluss 180 auf. Die Verarbeitungseinrichtung 170 ermittelt aus dem am ersten Eingangsanschluss 175 von der Aufbereitungseinrichtung 160 erhaltenen Signal $S_{ist}$' und dem am zweiten Eingangsanschluss 180 erhaltenem Sollwert $S_{soll}$, der ein Maß für die gewünschte Ist-Leistung darstellt, beispielsweise mittels eines Vergleichs ein Steuersignal $S_{steuer}$, welches wiederum an den Steuereingang 120 der Verstärkungseinrichtung 110 weitergeleitet wird. Die Verarbeitungseinrichtung 170 regelt dabei an deren Ausgangsanschluss das Steuersignal $S_{steuer}$ derart ein, dass sich ein bestimmtes Verhältnis zwischen dem Sollwert $S_{soll}$ und dem aufbereiteten Auskoppelsignal $S_{ist}$ der Aufbereitungseinrichtung 160 ergibt. Typischerweise wird die Differenz zwischen von dem Ausgabewert $S_{ist}$' der Aufbereitungseinrichtung 170 und dem Sollwert $S_{soll}$ ausgeregelt, so dass im Optimalfall gilt $S_{ist}$'$=S_{soll}$. Optional ist auch das Einregeln einer bestimmten Regelabweichung $\Delta S$ denkbar ($\Delta S = S_{ist}$'$-S_{soll}$). Die Verarbeitungseinrichtung 170 regelt den Steuereingang 120 der Verstärkungseinrichtung 110 und stellt damit deren Verstärkungsfaktor ein. Das geregelte Ausgangssignal $S_{out}$ liegt dann am Ausgangsanschluss 190 der Verstärkungsregelung, d.h. des erfindungsgemäßen Funkverstärkers vor.

Gemäß dem erfindungsgemäßen Konzept zur leistungseffizienten Verstärkungseinstellung, wird nun erfindungsgemäß die Eigenschaft ausgenutzt, dass bei elektronischen Verstärkern deren Funktionsparameter, wie Verstärkung, Linearität und Rauschverhalten, abhängig von dem Wert eines Betriebsparameters, z.B. ihrer Versorgungsspannung oder einer Vorspannung, ändern bzw. eingestellt werden können. Ebenso ändert sich in Abhängigkeit der Versorgungsspannung bzw. der Vorspannung der Stromverbrauch. So sind beispielsweise Verstärkung und Linearität proportional zum Wert eines Versorgungsstroms. Ein typisches allgemeines Beispiel für einen betriebsparameterabhängigen Verstärker ist ein Differenzverstärker.

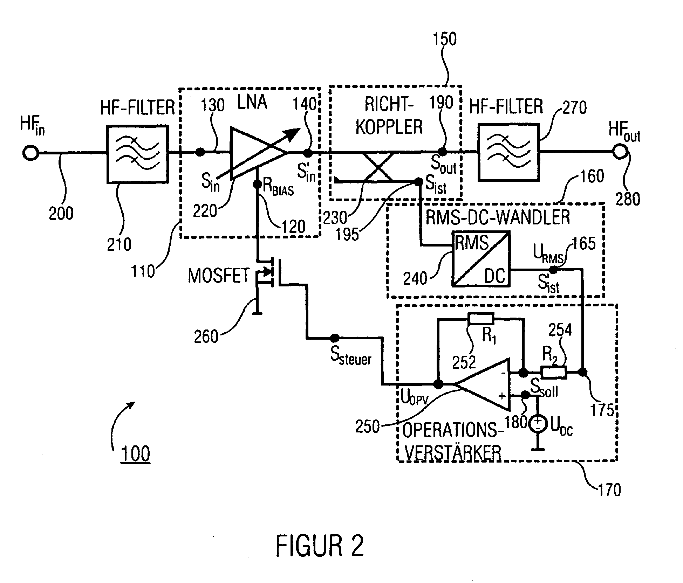

Im folgenden wird nun ausgehend von Fig. 2 detailliert eine mögliche technische Realisierung des in Fig. 1 prinzipiell dargestellten Ausführungsbeispiels erläutert. Zur Vereinfachung sind die Funktionsblöcke mit den zugehörigen Bezugszeichen aus Fig. 1 mit eingezeichnet.

Die im folgenden beschriebenen Signale beziehen sich wieder auf den Betriebszustand der erfindungsgemäßen Funkeinrichtung 100. Die in Fig. 2 gezeigte Realisierung einer erfindungsgemäßen Funkeinrichtung zeigt ein HF-Eingangssignal $HF_{in}$ an einem Eingangsanschluss 200, einen optionalen Hochfrequenzbandpassfilter 210, einen vorzugsweise rauscharmen, über einen Widerstand $R_{BIAS}$ steuerbaren Empfangsverstärker 220, der die Verstärkungseinrichtung 110 realisiert und erfindungsgemäß auch als Eingangsverstärker ausgeführt sein kann, einen Richtkoppler 230, der die Auskoppeleinrichtung 150 darstellt, einen RMS-DC-Wandler 240, der die Aufbereitungseinrichtung 160 realisiert, einen Operationsverstärker 250 mit zwei beschalteten Widerstandselementen 252 und 254 mit den Widerstandswerten $R_1$

und $R_2$, die der Verarbeitungseinrichtung 170 entsprechen, und einen Metalloxidschicht-Feldeffekttransistor 260 (MOSFET = Metalloxidschicht-Feldeffekttransistor), wobei der MOSFET einen gegen ein Bezugspotential (z.B. Masse) regelbaren Widerstand $R_{BIAS}$ darstellt. Optional kann der MOSFET erfindungsgemäß aber auch durch mehrere MOSFETs oder andere Transistoreinrichtungen (z.B. einen oder mehrere Bipolar-Transistoren oder allgemein Feldeffekttransistoren) realisiert werden. Weiterhin zeigt Fig. 2 einen zweiten optionalen Hochfrequenzfilter 270 und den Ausgangsanschluss 280 an dem das Hochfrequenzausgangssignal $HF_{out}$ ausgegeben wird.

Generell werden in Funkeinrichtungen 100 rauscharme Empfangsverstärker 220 eingesetzt, sogenannte Low-Noise Amplifier (LNA = Low-Noise Amplifier), die typischerweise nahe der Empfangsantenne im Empfangspfad angeordnet sind. Diese Verstärker 220 zeichnen sich durch geringe Rauschzahlen aus. Typische Werte für die Rauschzahlen liegen zwischen 1-5 dB und variieren je nach unterstützter Bandbreite (z.B. 5dB für eine Bandbreite von 2-20GHz), die Verstärkungsfaktoren liegen typischerweise etwa bei 10-40dB.

Der rauscharme Eingangsverstärker 220 (LNA - Low-Noise Amplifier) hat entscheidenden Einfluss auf das Rauschverhalten des gesamten Empfängers 100. Erfindungsgemäß wird nun ausgenutzt, das verschiedene bekannte LNA-Ausführungen die Möglichkeit bieten, mittels eines an den Steueranschluss 120 anliegenden Steuersignals $S_{steuer}$ die Verstärkung und gleichzeitig den Stromverbrauch der Komponente einzustellen und insbesondere zu reduzieren, der LNA 220 also betriebsparameterabhängig gesteuert werden kann. An diesem Anschluss 120 kann durch ein externes Widerstandselement die Verstärkung voreingestellt werden. Wird nun ein Widerstandselement mit einem einstellbaren Widerstandswert, wie z.B. ein Transistor 260, verwendet, so kann die Verstärkung über die Steuerspannung des Transistors 260 während des Betriebs variiert werden. Generell ist es natürlich auch denkbar, dass der Transistor 260 in den LNA 220 aufgenommen bzw. integriert ist, sodass der LNA 220 direkt von der OPV-Schaltung 250 mittels des Steuersignals $S_{steuer}$ gesteuert werden könnte.

Die erfindungsgemäße Funktionsweise und Regelung besteht nun darin, dass für die Regelung eines solchen LNAs 220 ein Richtkoppler 230 einen definierten Teil $S_{ist}$ des Ausgangssignals $S_{in}$' des LNAs 220 auskoppelt, wobei im allgemeinen beliebige Auskoppelelemente denkbar sind, wie z.B. (auch induktiv, kapazitiv) über einen Shunt-Widerstand, einen Richtkoppler etc. Dieser Anteil $S_{ist}$ des Signals $S_{in}$' wird nun einem RMS-DC-Konverter 240 zugeführt. In dem RMS-DC-Konverter 240 wird aus dem ausgekoppelten Signal $S_{ist}$ ein Gleichsignal $S_{ist}$' nach der quadratischen Mittelwertbildung (RMS = Root-Mean-Square) erzeugt. Dieser Wert stellt ein Maß für die Ist-Leistung.des Signals $S_{in}$' nach dem Verstärker 220 dar, prinzipiell sind auch andere Auswertenetzwerke denkbar, wie z.B. eine weitere OPV-Schaltung, die ein Eingangssignal quadriert und mittelt. Ein zu der Leistung des verstärkten Eingangssignals $S_{in}$' proportionales Ausgangssignal $S_{ist}$' ($U_{RMS}$) des RMS-DC-Konverters 240 wird zum Regler, bestehend aus dem OPV 250 (Operationsverstärker) mit zusätzlicher Beschaltung geführt. Der als invertierender Subtrahierer beschaltete OPV erzeugt das Ansteuersignal $S_{steuer}=U_{OPV}$ für den Transistor 260 nach der folgenden Formel:

$$U_{OPV} = U_{DC} \cdot \left(1 + \frac{R_1}{R_2}\right) - U_{RMS} \cdot \frac{R_1}{R_2}, \; mit \;\; U_{OPV} \triangleq S_{steuer}, U_{DC} \triangleq S_{soll}, U_{RMS} \triangleq S_{ist}{}'.$$

Der OPV 250 ist hierbei beispielsweise durch die Beschaltung mit den beiden Widerstandselemente 252 und 254 mit den Widerstandswerten $R_1$ und $R_2$ als invertierender Subtrahierer ausgebildet und realisiert so den Regler der Regelschleife. Prinzipiell sind auch andere OPV-Schaltungen und damit andere Realisierungen von Reglern möglich, z.B. integrative oder differentielle Regler, wobei die vorliegende Erfindung analoge und damit schnelle Bauelemente verwendet.

Aus dieser Beziehung wird ersichtlich, dass bei Erhöhung der Signalleistung und damit der Ausgangsspannung $U_{RMS}=S_{ist}$' des RMS-DC-Wandlers 240 das Ausgangssignal $U_{opv}=S_{steuer}$ des OPVs 250 zurückgeht. Mit diesem Signal $U_{opv}$ wird die Transistoreinrichtung 260 bzw. der LNA 220 über $S_{steuer}$ gesteuert und so die Verstärkung und damit der Versorgungsstrom eingeregelt. Beispielsweise wäre es auch denkbar, dass in Abhängigkeit einer Bitfehlerrate, wie sie z.B. von einem Basisbandprozessor bestimmt werden könnte, der Sollwert für die Verstärkungsregelung vorgegeben wird. Die Bitfehlerrate kann dabei nach dem Demodulieren im Basisband, d.h. auf Basis des Nutzsignals, bestimmt werden. Ein Detektor/Schätzer schätzt, aufbauend auf den empfangenen Symbolen, die gesendeten Daten, die dann einem Decodierer zugeführt werden. Die in derzeitigen Funksystemen verwendeten Codes, erlauben dabei, beispielsweise über Checksummen, eine Bitfehlerrate oder auch Blockfehlerrate zu bestimmen. Die Bitfehlerrate bzw. Blockfehlerrate wird von einem Decoder im Basisband bestimmt. Überschreitet die Bitfehlerrate ein vorgegebenes Maß, typische Werte sind 1-2%, so kann der Sollwert der Verstärkungseinstellung erhöht werden, daraufhin erhöht sich ebenfalls die zur Verfügung gestellte Leistung. Durch Erhöhung der Leistung wird das Signal-Rausch-Verhältnis und damit die Bitfehlerrate bzw. Blockfehlerrate wiederum verbessert. Eine Erhöhung der Verstärkung des Empfangsverstärkers wird somit ein Sinken der Bitfehlerrate zur Folge haben. Nach diesem Prinzip ist erfindungsgemäß auch eine bitfehlergesteuerte Eingangsverstärkungseinstellung möglich.

Durch weitere Beschaltung des OPVs mit Kondensatoren oder anderen diskreten Bauelementen kann die Dynamik des Regelkreises beeinflusst werden. Auf diese Art und Weise können verschiedene Reglertypen realisiert werden. Den Anforderungen des Regelkreises entsprechend, können verschiedene Regler, wie z.B. P-Regler (P = Proportional), PD-Regler (PD = Proportional Differentiell), PID-Regler (PID = Proportional Differentiell Integrativ), etc. zum Einsatz kommen.

Beispielsweise hängen die durch den Mobilfunkkanal verursachten Fluktuationen stark von der Geschwindigkeit der Mobilstationen ab, und sind somit bei Systemen, die vorwiegend im Wohnbereich zu Anwendung kommen (z.B. DECT), geringer als bei Mobilfunksystemen, die beispielsweise auch entlang von Straßen und Bahnstrecken zum Einsatz kommen (z.B. GSM, UMTS). Deshalb können die Anforderungen an den Regelkreis je nach Einsatzbereich variieren und können bei einer Realisierung berücksichtigt werden.

Erfindungsgemäß wird also die Verstärkung, der als LNA ausgebildeten Verstärkungseinrichtung 110, an den aktuellen Bedarf und damit an den Funkkanal angepasst, womit sich die Verlustleistung des Empfängers 100 reduziert. Erfindungsgemäß wird also eine Regelschleife zur Steuerung einer Versorgungs- oder Vorspannung des Verstärkers verwendet. Diese Regelschleife weist, gemäß der ersten Realisierung der Erfindung, ein Koppelelement, wie beispielsweise ein Richtkoppler 230, einen RMS-DC-Konverter 240 und einen Operationsverstärker 250 auf. Das Koppelelement 230 koppelt einen im Vergleich zur Ist-Leistung geringen Anteil des Signals $S_{ist}$' aus. Anschließend wird das Signal in einer Operationsverstärkerschaltung 250 (OPV) weiterverarbeitet. Die OPV-Schaltung 170 erzeugt ein Steuersignal $S_{steuer}$ für den Verstärker 220 im Empfänger 100 in der Weise, dass bei steigender Signalleistung die Verstärkung des Empfängers 100 reduziert wird. Dies kann auch über die Versorgungs- oder Vorspannung geschehen. Durch die dem Bedarf angepasste Verstärkung reduziert sich auch der Versorgungsstrom des Verstärkers 220. Der Sollwert $S_{soll}$ für die Leistung des Ausgangssignals des geregelten Verstärkers 220 kann mittels einer Gleichspannung $U_{DC}$ am positiven Eingangsanschluss 180 des OPVs eingestellt werden. So kann diese Regelschleife für beliebige Verstärker 220 eingesetzt werden.

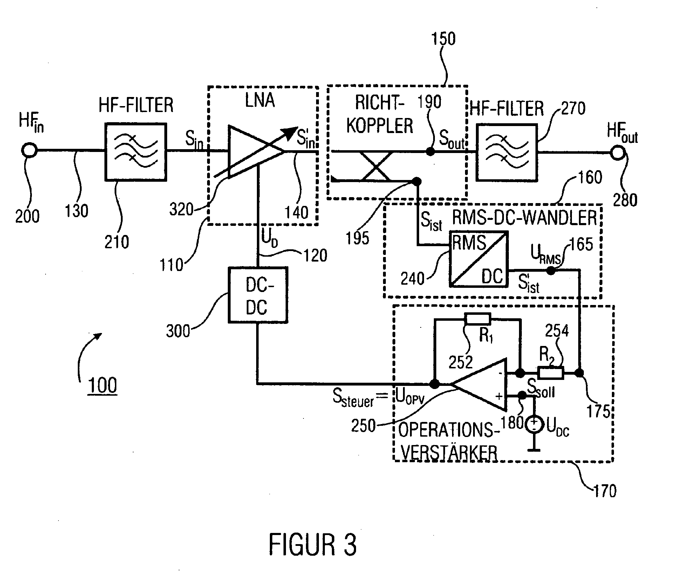

Fig. 3 zeigt eine weitere erfindungsgemäße Realisierung einer Schaltung zur leistungseffizienten Verstärkungseinstellung einer Funkeinrichtung 100, die hier als Funkempfänger dargestellt ist. Im Unterschied zu den Realisierungen in Fig. 2 ist , dass nun die Versorgungsspannung eines Eingangsverstärkers 320, der vorzugsweise wieder als LNA realisiert ist, über einen DC-DC-Wandler 300 geregelt wird.

Die Zuordnung zu den prinzipiellen Funktionsblöcken entsprechend Fig. 1 ist wiederum durch gestrichelte Blöcke angegeben. Die obigen Ausführungen sind somit auch auf die restlichen Funktionsblöcke und Schaltungselemente gleichermaßen auf die Empfängerschaltung 100 von Fig. 3 anwendbar.

Wie in Fig. 3 dargestellt ist, kann nun erfindungsgemäß mit dem Ausgangssignal $S_{steuer}$ des OPVs 250 auch ein einstellbarer Spannungsregler 300 (DC-DC-Wandler = Direct Current - Direct Current = Gleichstrom - Gleichstrom) gesteuert werden, der in Abhängigkeit eines Eingangssignals $S_{steuer}$ eine definierte Ausgangsspannung $U_{DC}$ liefert. So würde abhängig vom RMS-Wert $S_{ist}$'=$U_{RMS}$ des Verstärkerausgangssignals dessen Versorgungsspannung gesteuert. Besteht bei dem Verstärker ein Zusammenhang zwischen Versorgungsspannung, Verstärkung und Versorgungsstrom, so ist auch hier eine Reduzierung des Leistungsverbrauchs durch Verstärkungsreduzierung an dem Eingangsverstärker 320 zu erreichen.

Der DC-DC-Wandler 300 könnte auch in den LNA 320 integriert sein und dieser somit direkt von der OPV-Schaltung 250 gesteuert werden. Es ist auch denkbar, dass der DC-DC-Wandler 300 lediglich funktionell in den LNA 320 integriert ist und der LNA 320 nun in Abhängigkeit seiner Versorgungsspannung seine Verstärkung entsprechend einer Kennlinie einstellt. Prinzipiell sind viele Ansteuerbauteile bzw. Anpassungsnetzwerke zwischen OPV-Schaltung 250 und LNA 320 denkbar, wobei diese Anpassung sowohl in den LNA 320 als auch in die OPV-Schaltung 250 mit integriert sein können. Die Erfindung bezieht sich vorzugsweise auf LNAs, aber natürlich sind auch andere Verstärkerrealisierungen 110 erfindungsgemäß denkbar.

Im Rahmen der vorliegenden Erfindung gemäß der Fig. 1-3, kann durch weitere Beschaltung des OPVs 250 mit Kondensatoren, Induktivitäten etc., die Dynamik des Regelkreises beeinflusst werden. Auf diese Art und Weise können verschiedene Reglertypen realisiert werden. Den Anforderungen des Regelkreises entsprechend, können verschiedene Regler, wie z.B. P-Regler, PD-Regler, PID-Regler, etc. zum Einsatz kommen.

Weiterhin ist es möglich, die Signalleistung $S_{ist}$ nicht direkt nach dem LNA 220/320 auszukoppeln, sondern nach dem Kanalfilter 270 oder an späterer Stelle des Empfangszugs. So beeinflussen Störsignale außerhalb des gewünschten Frequenzbands nicht die Verstärkung der geregelten Komponenten. Dadurch ist dann die Eingangsleistung des RMS-DC-Wandlers höher und so dessen Messgenauigkeit größer.

Es ist ebenfalls möglich, basierend auf der Leistung eines einzelnen Kanals, die Leistung eines ganzen Übertragungsbandes, welches mehrere Kanäle enthält, über den Sollwert der Verstärkungsregelung zu regeln. Dabei kann beispielsweise die Leistung eines einzelnen Kanals stellvertretend zur Regelung der Leistung aller Kanäle verwendet werden. Als Beispiel wären Rundfunkempfänger zu nennen, die ein ganzes Spektrum an Kanälen (z.B. TV-Kanäle) empfangen. In einem solchen Fall wird davon ausgegangen, dass mehrere Kanäle die im Frequenzbereich benachbart sind, die gleichen Ausbreitungsbedingungen im Mobilfunkkanal vorfinden. Ein Rundfunkempfänger kann nun basierend auf der Leistung eines einzelnen Kanals, die Leistung einer Gruppe von Kanälen in einer gewissen Bandbreite nachregeln. Dieses Verfahren ist überall dort einsetzbar, wo sich ein Kanal repräsentativ für eine Gruppe von Kanälen einsetzen lässt, beispielsweise auch im Mobilfunk, wenn z.B. mehrere Kanäle zur Erhöhung der Benutzerdatenrate einem Benutzer zugeordnet werden.

Eine weitere Variante der effizienten Verstärkungseinstellung basierend auf Betriebsparametern wäre die Regelung basierend auf Störsignalen. In einem solchen Fall werden dann die Störsignale ausgekoppelt, und die Verstärkerleistung entsprechend der Störleistung eingeregelt. Dabei werden mit Hilfe von Filtern zunächst Nachbarkanäle selektiert und dort mittels eines RMS-DC-Wandlers die Leistung gemessen.

Um nachfolgende Verstärkerstufen nicht zu überlasten, kann nun die Verstärkung reduziert werden, wenn auf den Nachbarkanälen eine entsprechend starke Leistung gemessen wurde. Gerade im Hochfrequenzbereich und der dort eingesetzten Verstärkungsstufen ist es wichtig, diese in ihrem vorgesehenen Betriebsbereich zu betreiben. Wird ein solcher Verstärker bis an die Grenze seines Leistungsbereiches ausgesteuert, kommt es zu Sättigungseffekten. Durch diese Effekte kommt es zu Verzerrungen im Signalverlauf, bei mehreren gleichzeitigen Signalen kommt es zu Intermodulationsprodukten. Um nun eine solch hohe Aussteuerung eines Verstärkers zu vermeiden, ist es wichtig, dass dessen Eingangssignal auf den Betriebsbereich des Verstärkers einregelt wird.

Eine Realisierung der vorliegenden Erfindung vermag dies zu leisten. So könnte nun basierend auf der Leistung in einem gesamten Eingangsband, bzw. stellvertretend in einem einzelnen Kanal oder auch eines Nachbarkanals, die Leistung im gesamten Übertragungsband ermittelt werden und mittels der erfindungsgemäßen Regelung zur betriebsparameterabhängigen Verstärkungseinstellung auf den Eingangsbereich einer Verstärkerstufe eingeregelt werden.

Zusammenfassend lässt sich feststellen, dass die erfindungsgemäße Realisierung der leistungseffizienten Verstärkungseinstellung von Funkeinrichtungen, Verstärker bei geringerer Leistung betreibt und diese somit weniger Verlustleistung verbrauchen. Durch die Verwendung der RMS-DC-Wandler kann auf einfache, kostengünstige und leistungseffiziente Weise die Signalleistung an beliebigen Stellen des Empfängerpfads gemessen werden. Durch die Verwendung von rein analogen Schaltungen kann diese Regelschleife auch auf schnelle Signaländerungen reagieren und erhöht so das Einsparpotential bei starken Signalen und somit reduzierter Verstärkung. Eine Regelung des Verstärkers einer Funkeinrichtung kann somit erfindungsgemäß mit dem Ziel der Leistungsreduzierung stattfinden.

Das erfindungsgemäße Konzept ist sowohl auf Empfänger bzw. Empfangseinrichtungen, auf Sender bzw. Sendeeinrichtungen, als auch auf Sendeempfänger anwendbar. Zur Regelung eines Sendeverstärkers kann die erfindungsgemäße betriebsparameterabhängige Regelung ebenso eingesetzt werden. Da an einem Sender die Schwankungen, die durch den Mobilfunkkanal verursacht werden, noch nicht bekannt sind, können diese beispielsweise über einen Feedback-Kanal vom Empfänger mitgeteilt werden. Basierend auf diesem Feedback kann nun der Sender seine Leistung einregeln. Weiterhin wäre auch eine Kombination der erfindungsgemäßen Vorrichtung in einem Sender und einem Empfänger denkbar. In diesem Falle würde der Empfänger eine erfindungsgemäße betriebsparameterabhängige Regelung zur Verstärkungseinstellung an einer Empfangsverstärkungseinrichtung verwenden und der Sender eine erfindungsgemäße betriebsparameterabhängige Regelung zur Verstärkungseinstellung seines Sendeverstärkers. Auch in diesem Szenario wäre es denkbar, dass der Empfänger an den Sender Informationen hinsichtlich der Verstärkungseinstellung bzw. hinsichtlich der durch den Mobilfunkkanal hervorgerufenen Leistungsschwankungen übermittelt.

Das erfindungsgemäße Konzept zur betriebsparameterabhängigen Verstärkungseinstellung ist sowohl für stationäre Funkeinrichtungen als auch für mobile Funkeinrichtungen vorteilhaft. In einer Sendeeinrichtung kann die erfindungsgemäße Regelung zur Verstärkungseinstellung neben einer Reduzierung der Leistungsaufnahme damit auch die thermische Belastung, beispielsweise einer Sendeendstufe, reduzieren. Analog zu einer Empfangseinrichtung wird in der Sendeeinrichtung die Sendeleistung an die Kanaleigenschaften angepasst, und somit nur so viel Sendeleistung eingesetzt, wie gerade notwendig ist. Dadurch wird auch die thermische Belastung eines Senders auf ein effizienteres Maß reduziert. Die genannten Vorteile durch eine bedarfsgerechte Verstärkungseinstellung finden sich analog auch in Sendeempfangsvorrichtungen bzw. Sendeempfängern wieder.

**Patentansprüche**

1. Vorrichtung zur betriebsparameterabhängigen Verstärkungsregelung in einer Funkeinrichtung(100), mit folgenden Merkmalen:

   einer rauscharmen HF-Eingangsverstärkungseinrichtung (110), deren Rauschzahl F in einem Bereich von 1-5dB liegt, mit einem Steueranschluss (120), einem Eingangsanschluss (130) und einem Ausgangsanschluss (140), wobei die Verstärkungseinrichtung (110) ausgebildet ist, um ein an dem Eingangsanschluss (110) anliegendes Eingangssignal $S_{in}$ mit einem über den Steueranschluss (120) einstellbaren Verstärkungsfaktor zu verstärken, um an dem Ausgangsanschluss (140) das verstärkte Eingangssignal $S_{in}'$ bereitzustellen;

einer Auskoppeleinrichtung (150), die der Verstärkungseinrichtung (110) ausgangsseitig nachgeschaltet ist, und die ausgebildet ist, um ein Auskoppelsignal $S_{ist}$ bereitzustellen, das von dem verstärkten Eingangssignal $S_{in}$' abhängt;

einer Aufbereitungseinrichtung (160), die einen RMS-DC-Wandler (240) aufweist und die ausgebildet ist, um das Auskoppelsignal $S_{ist}$ analog aufzubereiten, um ein aufbereitetes Signal $S_{ist}$' bereitzustellen, das ein Maß für eine von der Verstärkungseinrichtung (110) bereitgestellte Ist-Leistung des verstärkten Eingangssignals Sin' ist;

einer Verarbeitungseinrichtung (170), die ausgebildet ist, um das aufbereitete Signal $S_{ist}$' mit einem Sollwert $S_{soll}$ analog zu vergleichen und ein Vergleichssignal $S_{steuer}$ basierend auf dem Vergleich bereitzustellen, wobei die Verstärkungseinrichtung (110) basierend auf dem Vergleichssignal an dem Steuereingang (120) zur Regelung des Verstärkungsfaktors ansteuerbar ist, um zwischen Soll-Leistung und Ist-Leistung ein vorbestimmtes Verhältnis einzustellen, wobei der Sollwert $S_{soll}$ ein Maß für die Soll-Leistung des verstärken Eingangssignals $S_{in}$' ist.

2. Vorrichtung gemäß Anspruch 1, wobei die Auskoppeleinrichtung (150) einen Richtkoppler (230) zum Auskoppeln eines von der Ist-Leistung des verstärkten Eingangssignals $S_{in}$' abhängigen Auskoppelsignals $S_{ist}$ aufweist.

3. Vorrichtung gemäß einem der Ansprüche 1 oder 2, wobei die Aufbereitungseinrichtung (160) das Auskoppelsignal $S_{ist}$ derart aufbereitet, dass es ein Maß für die von der Verstärkungseinrichtung (110) abgegebene Ist-Leistung darstellt.

4. Vorrichtung gemäß Anspruch 3, wobei das ausgekoppelte Signal $S_{ist}$ quadriert und gemittelt wird, so dass $S_{ist}$' einem gemittelten Wert aufweist, der proportional zu der von der Verstärkungseinrichtung (110) abgegebenen Ist-Leistung ist.

5. Vorrichtung gemäß einem der Ansprüche 1 bis 4, wobei der RMS-DC-Wandler ausgebildet ist, um das Auskoppelsignal $S_{ist}$ zu quadrieren und zu mitteln, um das quadrierte und gemittelte Auskoppelsignal $S_{ist}$' Signal an seinem Ausgangsanschluss bereitzustellen.

6. Vorrichtung gemäß der Ansprüche 1 bis 5, wobei die Verarbeitungseinrichtung (170) eine Operationsverstärkerschaltung aufweist.

7. Vorrichtung gemäß Anspruch 6, wobei die Operationsverstärkerschaltung eine Differenzverstärkerschaltung aufweist.

8. Vorrichtung gemäß einem der Ansprüche 1 bis 7, wobei die Verstärkung der Verstärkungseinrichtung (110) über ein resistives Element mit einem steuerbaren Widerstand, $R_{BIAS}$, an dem Steueranschluss (120) einstellbar ist.

9. Vorrichtung gemäß Anspruch 8, wobei das resistive Element eine Transistoreinrichtung aufweist, wobei die Verarbeitungseinrichtung (170) die Transistoreinrichtung (260) mit einem Steuersignal $S_{steuer}$ aussteuert, um einen Widerstandswert gegen ein Bezugspotential einzustellen.

10. Vorrichtung gemäß einem der Ansprüche 1 bis 7, wobei die Verstärkung der Verstärkungseinrichtung (110) über eine Versorgungsspannung $U_D$ an dem Steueranschluss (120) einstellbar ist.

11. Vorrichtung gemäß Anspruch 10, wobei die Verarbeitungseinrichtung (170) ausgebildet ist, um die Versorgungsspannung an dem Steueranschluss (120) der Verstärkungseinrichtung (110) von der Verarbeitungseinrichtung (170) über einen regelbaren Spannungswandler (300) einzustellen.

12. Vorrichtung gemäß einem der Ansprüche 1 bis 11, wobei der Sollwert $S_{soll}$ proportional zur gewünschten Soll-Leistung ist.

13. Vorrichtung gemäß einem der Ansprüche 1 bis 12, wobei die Verarbeitungseinrichtung (170) ausgebildet ist, um die Ist-Leistung innerhalb eines Toleranzbereichs gleich der Soll-Leistung einzuregeln.

14. Vorrichtung gemäß einem der Ansprüche 1 bis 13, wobei die Funkeinrichtung ein Mobilfunkgerät ist.

15. Vorrichtung gemäß einem der Ansprüche 1 bis 14, wobei die Funkeinrichtung ein Sender, ein Empfänger oder ein Sendeempfänger ist.

16. Verfahren zur betriebsparameterabhängigen Regelung einer Verstärkung einer Funkeinrichtung, mit folgenden Schritten:

Empfangen eines HF-Eingangssignals an einem Eingangsanschluss, Ausgeben eines Ausgangssignals an einem Ausgangsanschluss und Empfangen eines Steuersignals an einem Steueranschluss, wobei das HF-Eingangssignal mit einem dem Steuersignal entsprechenden Verstärkungsfaktor verstärkt wird, wobei ein hinzugefügtes Rauschen auf einer Rauschzahl F in einem Bereich von 1-5dB basiert, und am Ausgangsanschluss das Ausgangssignal als verstärktes HF-Eingangssignal ausgegeben wird;
Auskoppeln eines Signalanteils des verstärkten HF-Eingangssignals, wobei das ausgekoppelte Signal vom verstärkten HF-Eingangssignal abhängt, analoges Aufbereiten des ausgekoppelten verstärkten HF-Eingangssignals unter Verwendung eines RMS-DC-Wandlers, so dass das aufbereitete Signal ein Maß für eine Ist-Leistung des verstärkten HF-Eingangssignals darstellt;
Verarbeiten des ausgekoppelten und aufbereiteten Signals, wobei das aufbereitete Signal analog mit einem vorgegebenen Sollwert verglichen wird und basierend auf dem Vergleich ein Vergleichssignal ausgegeben wird, wobei basierend auf dem Vergleichssignal der Verstärkungsfaktor regelbar ist, um zwischen Soll-Leistung und Ist-Leistung auf ein bestimmtes Verhältnis einzustellen.

17. Verfahren gemäß Anspruch 16, wobei das Verhältnis zwischen Ist-Leistung und Soll-Leistung innerhalb eines Toleranzbereichs so eingestellt wird, das Ist-Leistung und Soll-Leistung gleich sind.

**Claims**

1. An apparatus for operating parameter-dependent gain adjustment in a radio device (100), comprising:

a low-noise RF input amplification means (110) the noise figure F of which ranges from 1-5 dB, comprising a control terminal (120), an input terminal (130) and an output terminal (140), the amplification means (110) being implemented to amplify an input signal Sin present at the input terminal (110) by a gain factor adjustable via the control terminal (120), so as to provide the amplified input signal Sin' at the output terminal (140);
a decoupling means (150) connected downstream from the amplification means (110) on the output side and implemented to provide a decoupling signal $S_{actual}$ which depends on the amplified input signal $S_{in}$';
a preparation means (160) comprising an RMS DC converter (240) and implemented to prepare the decoupling signal $S_{actual}$ in an analog manner in order to provide a prepared signal $S_{actual}$' which is a measure of an actual power, provided by the amplification means (110), of the amplified input signal $S_{in}$';
a processing means (170) implemented to compare the prepared signal $S_{actual}$' to a target value $S_{target}$ in an analog manner and to provide a comparison signal $S_{control}$ on the basis of the comparison, the amplification means (110) being drivable on the basis of the comparison signal at the control input (120) for controlling the gain factor, so as to adjust a predetermined ratio between the target power and the actual power, the target value $S_{target}$ being a measure of the target power of the amplified input signal $S_{in}$'.

2. The apparatus as claimed in claim 1, wherein the decoupling means (150) comprises a directional coupler (230) for decoupling a decoupling signal $S_{actual}$ dependent on the actual power of the amplified input signal $S_{in}$'.

3. The apparatus as claimed in one of claims 1 or 2, wherein the preparation means (160) prepares the decoupling signal $S_{actual}$ such that it represents a measure of the actual power output by the amplification means (110).

4. The apparatus as claimed in claim 3, wherein the decoupled signal $S_{actual}$ is squared and averaged, so that $S_{actual}$' comprises an averaged value which is proportional to the actual power output by the amplification means (110).

5. The apparatus as claimed in any of claims 1 to 4, wherein the RMS DC converter is implemented to square and to average the decoupling signal $S_{actual}$ so as to provide the squared and averaged decoupling signal $S_{actual}$' at its output terminal.

6. The apparatus as claimed in any of claims 1 to 5, wherein the processing means (170) comprises an operational-amplifier circuit.

**7.** The apparatus as claimed in claim 6, wherein the operational-amplifier circuit comprises a differential-amplifier circuit.

**8.** The apparatus as claimed in any of claims 1 to 7, wherein the gain of the amplification means (110) is adjustable via a resistive element comprising a controllable resistance, thus $R_{BIAS}$, at the control terminal (120).

**9.** The apparatus as claimed in claim 8, wherein the resistive element comprises a transistor means, the processing means (170) driving the transistor means (260) using a control signal $S_{control}$ so as to adjust a resistance with respect to a reference potential.

**10.** The apparatus as claimed in any of claims 1 to 7, wherein the gain of the amplification means (110) is adjustable via a supply voltage $U_D$ at the control terminal (120).

**11.** The apparatus as claimed in claim 10, wherein the processing means (170) is implemented to adjust the supply voltage at the control terminal (120) of the amplification means (110) by the processing means (170) via a controllable voltage converter (300).

**12.** The apparatus as claimed in any of claims 1 to 11, wherein the target value $S_{target}$ is proportional to the target power desired.

**13.** The apparatus as claimed in any of claims 1 to 12, wherein the processing means (170) is implemented to control the actual power to be equal to the target power, within a tolerance range.

**14.** The apparatus as claimed in any of claims 1 to 13, wherein the radio device is a mobile radiocommunication device.

**15.** The apparatus as claimed in any of claims 1 to 14, wherein the radio device is a transmitter, a receiver or a transceiver.

**16.** A method for operating parameter-dependent control of a gain of a radio device, comprising:

receiving an RF input signal at an input terminal, outputting an output signal at an output terminal, and receiving a control signal at a control terminal, the RF input signal being amplified by a gain factor which corresponds to the control signal, an added noise being based on a noise figure F within a range from 1 to 5 dB, and the output signal being output as an amplified RF input signal at the output terminal;
decoupling a signal portion of the amplified RF input signal, the decoupled signal depending on the amplified RF input signal, preparing the decoupled amplified RF input signal using an RMS DC converter in an analog manner, so that the prepared signal represents a measure of an actual power of the amplified RF input signal; processing the decoupled and prepared signal, the prepared signal being compared, in an analog manner, to a predefined target value, and a comparison signal being output on the basis of the comparison, the gain factor being controllable on the basis of the comparison signal, so as to adjust a specific ratio between the target power and the actual power.

**17.** The method as claimed in claim 16, wherein the ratio between the actual power and the target power is adjusted, within a tolerance range, such that the actual power and the target power are identical.

**Revendications**

**1.** Dispositif de réglage d'amplification en fonction des paramètres de fonctionnement dans un dispositif radio (100), aux caractéristiques suivantes:

un moyen d'amplification d'entrée HF à faible bruit (110) dont le facteur de bruit F se situe dans une plage de 1 à 5 dB, avec une connexion de commande (120), une connexion d'entrée (130) et une connexion de sortie (140), le moyen d'amplification (110) étant réalisé de manière à amplifier un signal d'entrée $S_{in}$ présent à la connexion d'entrée (110) par un facteur d'amplification réglable par l'intermédiaire de la connexion de commande (120), pour mettre à disposition, à la connexion de sortie (140), le signal d'entrée amplifié $S_{in}'$;
un moyen de découplage (150) connecté, du côté de la sortie, en aval du moyen d'amplification (110) et réalisé de manière à mettre à disposition un signal de découplage $S_{ist}$ qui est fonction du signal d'entrée amplifié $S_{in}'$;
un moyen de préparation (160) présentant un convertisseur RMS-DC (240) et réalisé de manière à préparer de manière analogique le signal de découplage $S_{ist}$, pour mettre à disposition un signal préparé $S_{ist}'$ qui est

une mesure pour la puissance réelle du signal d'entrée amplifié $S_{in}$' mis à disposition par le moyen d'amplification (110);

un moyen de traitement (170) réalisé de manière à comparer de manière analogique le signal préparé $S_{ist}$' avec une valeur de consigne $S_{soll}$ et à mettre à disposition un signal de comparaison $S_{steuer}$ sur base de la comparaison, le moyen d'amplification (110) étant activable sur base du signal de comparaison à l'entrée de commande (120) pour régler le facteur d'amplification, pour régler, entre la puissance de consigne et la puissance réelle, un rapport prédéterminé, la valeur de consigne $S_{soll}$ étant une mesure pour la puissance de consigne du signal d'entrée amplifié $S_{in}$'.

2. Dispositif selon la revendication 1, dans lequel le moyen de découplage (150) présente un coupleur directif (230) destiné à découpler un signal de découplage $S_{ist}$ fonction de la puissance réelle du signal d'entrée amplifié $S_{in}$'.

3. Dispositif selon l'une des revendications 1 ou 2, dans lequel le moyen de préparation (160) prépare le signal de découplage $S_{ist}$ de sorte qu'il représente une mesure pour la puissance réelle délivrée par le dispositif d'amplification (110).

4. Dispositif selon la revendication 3, dans lequel le signal découplé $S_{ist}$ est élevé au carré et ramené à une moyenne, de sorte que $S_{ist}$' présente une valeur moyenne qui est proportionnelle à la puissance réelle délivrée par le dispositif d'amplification (110).

5. Dispositif selon l'une des revendications 1 à 4, dans lequel le convertisseur RMS-DC est réalisé de manière à élever au carré et ramener à une moyenne le signal de découplage $S_{ist}$, pour mettre à disposition, à sa connexion de sortie, le signal de découplage $S_{ist}$' élevé au carré et ramené à une moyenne.

6. Dispositif selon les revendications 1 à 5, le moyen de traitement (170) présentant un circuit d'amplificateur opérationnel.

7. Dispositif selon la revendication 6, dans lequel le circuit d'amplificateur opérationnel présente un circuit d'amplificateur différentiel.

8. Dispositif selon les revendications 1 à 7, dans lequel l'amplification du moyen d'amplification (110) est réglable par l'intermédiaire d'un élément résistif à résistance contrôlable, $R_{BIAS}$, à la connexion de commande (120).

9. Dispositif selon la revendication 8, dans lequel l'élément résistif présente un moyen transistor, dans lequel le moyen de traitement (170) commande le moyen transistor (260) par un signal de commande $S_{steuer}$, pour régler une valeur de résistance à un potentiel de référence.

10. Dispositif selon les revendications 1 à 7, dans lequel l'amplification du moyen d'amplification (110) est réglable par l'intermédiaire d'une tension d'alimentation $U_D$ à la connexion de commande (120).

11. Dispositif selon la revendication 10, dans lequel le moyen de traitement (170) est réalisé de manière à régler la tension d'alimentation à la connexion de commande (120) du moyen d'amplification (110) du moyen de traitement (170) par l'intermédiaire d'un convertisseur de tension réglable (300).

12. Dispositif selon les revendications 1 à 11, dans lequel la valeur de consigne $S_{soll}$ est proportionnelle à la puissance de consigne désirée.

13. Dispositif selon les revendications 1 à 12, dans lequel le moyen de traitement (170) est réalisé de manière à régler la puissance réelle dans une plage de tolérance égale à la puissance de consigne.

14. Dispositif selon les revendications 1 à 13, dans lequel le dispositif radio est une station mobile.

15. Dispositif selon les revendications 1 à 14, dans lequel le dispositif radio est un émetteur, un récepteur ou un émetteur-récepteur.

16. Procédé de réglage en fonction de paramètres de fonctionnement d'une amplification d'un dispositif radio, aux étapes suivantes consistant à:

recevoir un signal d'entrée HF à une connexion d'entrée, sortir un signal de sortie à une connexion de sortie et recevoir un signal de commande à une connexion de commande, le signal d'entrée HF étant amplifié par un facteur d'amplification correspondant au signal de commande, un bruit ajouté étant basé sur un facteur de bruit F dans une plage de 1 à 5 dB, et le signal de sortie étant sorti à la connexion de sortie comme signal d'entrée HF amplifié;

découpler une part de signal du signal d'entrée HF amplifié, le signal découplé étant fonction du signal d'entrée HF amplifié, préparer de manière analogique le signal d'entrée HF amplifié découplé à l'aide d'un convertisseur RMS-DC, de sorte que le signal préparé représente une mesure pour une puissance réelle du signal d'entrée HF amplifié;

traiter le signal découplé et préparé, le signal préparé étant comparé de manière analogique à une valeur de consigne prédéterminée et un signal de comparaison étant sorti sur base de la comparaison, le facteur d'amplification étant réglable sur base du signal de comparaison, pour régler à un rapport déterminé entre la puissance de consigne et la puissance réelle.

17. Procédé selon la revendication 16, dans lequel le rapport entre la puissance réelle et la puissance de consigne est réglé dans une plage de tolérance de sorte que la puissance réelle et la puissance de consigne soient égales.

FIGUR 1

FIGUR 2

FIGUR 3

FIGUR 4

FIGUR 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5311143 A
- US 53111143 B
- US 6642784 B2
- US 4422047 A